(19) Europäisches Patentamt
European Patent Office
Office européen des brevets

(11) **EP 3 589 961 B1**

(12) **EUROPÄISCHE PATENTSCHRIFT**

(45) Veröffentlichungstag und Bekanntmachung des Hinweises auf die Patenterteilung:
**06.01.2021 Patentblatt 2021/01**

(21) Anmeldenummer: **18716986.7**

(22) Anmeldetag: **04.04.2018**

(51) Int Cl.:
*G01D 3/02* (2006.01)    *G01R 15/08* (2006.01)
*G01R 15/18* (2006.01)    *G01R 15/20* (2006.01)
*G01R 33/00* (2006.01)

(86) Internationale Anmeldenummer:
**PCT/EP2018/058588**

(87) Internationale Veröffentlichungsnummer:
**WO 2018/185151 (11.10.2018 Gazette 2018/41)**

(54) **VERFAHREN ZUR STROMMESSUNG UND STROMMESSVORRICHTUNG**

METHOD FOR MEASURING A CURRENT AND CURRENT MEASUREMENT DEVICE

PROCÉDÉ ET DISPOSITIF DE MESURE DE COURANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.04.2017 EP 17165542**

(43) Veröffentlichungstag der Anmeldung:
**08.01.2020 Patentblatt 2020/02**

(73) Patentinhaber: **Siemens Aktiengesellschaft 80333 München (DE)**

(72) Erfinder:
- **CHAHID, Abderrahim**
  **91334 Hemhofen (DE)**
- **HOFFMANN, Ingolf**
  **91074 Herzogenaurach (DE)**
- **ITZKE, Alexander**
  **90443 Nürnberg (DE)**
- **WEISS, Roland**
  **91058 Erlangen (DE)**

(56) Entgegenhaltungen:
**US-A1- 2005 156 587    US-A1- 2010 001 716**
**US-A1- 2014 218 018**

- **J. LENZ ET AL: "Magnetic sensors and their applications", IEEE SENSORS JOURNAL., Bd. 6, Nr. 3, 1. Juni 2006 (2006-06-01), Seiten 631-649, XP055417848, US ISSN: 1530-437X, DOI: 10.1109/JSEN.2006.874493**
- **Slawomir Tumanski: "Magnetic field sensors - Classification" In: "Handbook of Magnetic Measurements", 23. Juni 2011 (2011-06-23), XP055417849, ISBN: 978-1-4398-2951-6 Seiten 159-160, das ganze Dokument**
- **Anonymous: "DRV425 Fluxgate Magnetic-Field Sensor", , 31. März 2016 (2016-03-31), XP055414701, Gefunden im Internet: URL:http://www.ti.com/lit/ds/sbos729a/sbos729a.pdf [gefunden am 2017-11-30]**

**Beschreibung**

Die Erfindung betrifft ein Verfahren zur Strommessung mittels einer Strommessvorrichtung.

Strommessvorrichtungen, auch als Stromsensoren bezeichnet, werden angewendet, um an bestimmten Stellen innerhalb von elektrischen Anlagen Ströme zu messen bzw. zu bestimmen. Dabei wird eine Sensoranordnung für eine Strommessvorrichtung und ein entsprechendes Auswerteverfahren betrachtet, die eine energieeffiziente Messung von Strömen zwischen 400A und 10kA ohne Flusskonzentrator (Flusskreises) ermöglichen. Diese Sensoranordnung kommt ohne Eisenkreis aus und ermöglicht eine im Vergleich zum Stand der Technik verbesserte Störempfindlichkeit gegenüber den Feldern paralleler Störleiter wie sie in einem Drei-Phasen-Drehstromsystem üblich sind. Solche Stromsensoren können Anwendung in Umrichtern für Nieder- und Mittelspannung oder in Batterieüberwachung finden. Vor allem Umrichter für Schiffs- und Bahnantriebe oder Windkraftanlagen bewegen sich in diesem Strombereich und werden häufig so kompakt aufgebaut, dass hohe Fremdfelder, aber auch überlagerte Eigenfelder (Stromschienenrückführung) am Ort der Strommessung üblich sind. Infolge des "open loop"-Betriebs wird der Messbereich der Sensoranordnung durch den Messbereich des einzelnen Sensors begrenzt. Darüber hinaus weisen die Magnetfeldsensoren, die den für die Maximalfelder nötigen Messbereich besitzen, (ca. 50mT) einen relativ großen Offset-Fehler von deutlich über 1% des Maximalwertes auf. In diesem Feldbereich arbeiten fast ausschließlich Hall-Sensoren, welche für ihre Offset-Fehler bekannt sind. Da sich der Offset-Fehler der Einzelsensoren mit der Temperatur und über die Zeit ändert, ist eine zusätzliche analoge oder digitale Offset-Stabilisierung schwierig.

Bisher wird der Strom z.B. mit Shuntwiderständen, Ringkernwandlern, Rogowskispulen oder einzelnen Feldsonden (Hallsonde oder GMR-Sensor) gemessen. Bei den bisher bekannten Messaufbauten wird der vergleichsweise große Offsetfehler und die damit verbundene geringe Genauigkeit bei kleinen Strömen akzeptiert. Dabei ist zu erwähnen, dass eine einfache direkte Kompensation des beobachteten Offsetfehlers wegen dessen nicht deterministischen Zeitverhaltens und des stark nichtlinearen Temperaturverhaltens nur schwer möglich ist. Der Messbereich der Sensoranordnung ergab sich aus dem Messbereich der verfügbaren Einzelsensoren. Da die verfügbare Hall-Technologie Sensoren bei einem Messbereich von ca. 25mT und größer eine sehr gute Genauigkeit ermöglichen und die alternativ dazu verfügbare MR-Technologie nur Sensoren mit einem Messbereich bis 1mT ermöglicht, bestand lange eine große Lücke im Messbereich für "Chip-scale" Magnetfeld Sensoren. Darüber hinaus dekalibrierten die MR-Sensoren bei Feldern von größer ca. 20mT in einem Maße, das die Genauigkeit deutlich verschlechtert. Strommessvorrichtungen mit Magnetfeldsensoren sind aus US2010/001716, US2005/156587 und US2014/218018 bekannt.

Der Erfindung liegt die Aufgabe zugrunde, eine Strommessvorrichtung anzugeben, die eine höhere Genauigkeit bei der Strommessung ermöglicht.

Diese Aufgabe wird durch ein Verfahren zur Strommessung mittels einer Strommessvorrichtung gelöst, wobei die Strommessvorrichtung mindestens zwei Sensoren eines ersten Typs mindestens zwei Sensoren eines zweiten Typs aufweist, wobei die Sensoren des ersten Typs Flux-Gate Feldsensoren und die Sensoren des zweiten Typs Hall-Sensoren sind, wobei die Sensoren des ersten Typs eine höhere Empfindlichkeit aufweisen als die Sensoren des zweiten Typs, wobei die ersten Sensoren radialsymmetrisch auf einer ersten umlaufenden Bahn, insbesondere einer Ellipse oder einer ersten Kreisbahn, und die zweiten Sensoren radialsymmetrisch auf einer zweiten umlaufenden Bahn, insbesondere einer Ellipse oder einer zweiten Kreisbahn, angeordnet sind, wobei jeweils ein Sensor des ersten Typs benachbart zu einem Sensor des zweiten Typs angeordnet ist, wobei zur Bestimmung der Stromstärke mindestens einer der Sensoren des ersten Typs ausgewertet wird, falls die Messwerte mindestens zweier Sensoren des ersten Typs innerhalb des Messbereichs liegen und ansonsten mindestens ein Sensor des zweiten Typs ausgewertet wird.

Weitere vorteilhafte Ausgestaltungen der Erfindung sind in den abhängigen Ansprüchen angegeben.

Der Erfindung liegt die Erkenntnis zugrunde dass sich die Messgenauigkeit einer ringförmigen Anordnung von Einzelsensoren dadurch verbessern, dass jeweils an der Messstelle bzw. den Messstellen Sensoren unterschiedlichen Typs so angeordnet werden, dass sie zum Einen in möglichst direkter Nähe zu einander sind und zum Anderen alle Sensoren eines Typs eine eigenständige, möglichst radialsymmetrische Messanordnung bilden. Dabei sind die beiden Sensoren unterschiedlichen Typs an einer Messstelle benachbart zueinander angeordnet. Das bedeutet, dass ihr Abstand zueinander geringer ist als eine Ausdehnung eines der Sensoren. Neben einer Verbesserung der Messgenauigkeit kann durch diese Anordnung zudem der Messbereich erweitert werden. Dabei können die Sensoren unterschiedlichen Typs tangential oder radial benachbart angeordnet sein.

Mit Empfindlichkeit, auch als Auflösung bezeichnet, versteht man die Eigenschaft, eine Veränderung eines Messwertes erfassen zu können. Je höher die Empfindlichkeit, desto geringere Veränderungen der Messgröße lassen sich damit erfassen.

Die Erweiterung des Messbereichs sowie die Erhöhung der Messgenauigkeit durch die Strommessvorrichtung lassen sich durch ein Verfahren zur Strommessung erreichen. Dabei lassen sich diese Vorteile durch eine vorteilhafte Umschaltmethode zwischen den Sensoren unterschiedlichen Typs erreichen. Durch Untersuchungen auf Basis von realen Messdaten, unter Berücksichtigung von Störungen durch weitere stromführende Leiter, konnte gezeigt werden, dass eine typenweise Sensor-Umschaltung allen anderen Methoden in signifikantem Maße überlegen ist. Die typenweise Sensor-Umschaltung erfolgt derart, dass alle Sensoren vom ersten Typ mit einer hohen Empfindlichkeit immer dann zur Berechnung des Stromwertes verwendet werden, wenn mehrere Sensoren, d.h. mindestens zwei Sensoren, vom ersten Typ jeweils individuelle gültige Werte innerhalb Ihres Messbereiches liefern. Dabei sind individuell gültige Messwerte diejenigen, die innerhalb des zulässigen Messbereichs des Sensors liegen. Ansonsten werden immer die Sensoren vom zweiten Typ zur Berechnung des Stromwertes verwendet. Das heißt, wenn sich mindestens zwei Sensoren vom ersten Typ gleichzeitig innerhalb ihres Magnetfeld-Messbereiches befinden, werden die Signale der Sensoren vom ersten Typ zur Stromberechnung verwendet ansonsten werden die Signale der Sensoren vom zweiten Typ zur Stromberechnung verwendet.

Die Sensoren vom ersten Typ und vom zweiten Typ bilden dabei jeweils zwei konzentrische ringförmige Anordnungen von Sensoren mit paralleler Ausrichtung der feldempfindlichen Richtung. Bei Übersteuern eines einzelnen Sensors findet jedoch keine sensorweise Umschaltung statt. Um gute Messergebnisse zu erzielen, wird eine typenweise Umschaltung vorgenommen. Die Vorteile dieses Verfahrens liegen in einer Erweiterung des Messbereiches, einer generellen Erhöhung der Genauigkeit und einer möglichen Reduktion des Offsetfehlers.

Die Sensoren des ersten Typs sind Flux-Gate Feldsensoren und die Sensoren des zweiten Typs Hall-Sensoren. Diese Sensoren sind am Markt günstig verfügbar. Darüber hinaus ist deren Baugröße entsprechend klein, so dass diese sich auf einfache Weise in eine Messvorrichtung integrieren lassen.

Der Fachmann weiß, wie beispielsweise in der frei zugänglichen Enzyklopädie wikipedia beschrieben, dass der Messbereich derjenige Bereich einer Messgröße ist, in dem die Messabweichungen innerhalb festgelegter Grenzen bleiben. Die festgelegten Fehlergrenzen sind nur im definierten Messbereich gültig. Außerhalb des Messbereiches wird zur Genauigkeit nichts garantiert. Auch bei Flux-Gate Feldsensoren und Hall-Sensoren ist der Messbereich im Datenblatt angegeben.

Bei der Ausgestaltung der Erfindung weisen die Sensoren des ersten Typs eine um den Faktor 5 bis 20 höhere Empfindlichkeit auf als die Sensoren des zweiten Typs. Es hat sich gezeigt, dass sich hiermit ein besonders geringer Offsetfehler erreichen lässt. Ist die Empfindlichkeit der Sensoren vom ersten Typ um den Faktor von 5 bis 20 verglichen mit den Sensoren vom zweiten Typ größer, lässt sich in der Praxis bezogen auf den Messbereich ein sehr kleiner Offsetfehler erreichen. Damit lassen sich die Messbereiche der einzelnen Sensoren unterschiedlicher Typen auf sinnvolle Weise derart staffeln, um den Messfehler gering zu halten.

Bei einer weiteren vorteilhaften Ausgestaltung der Erfindung wird zur Bestimmung der Stromstärke mindestens einer der Sensoren des ersten Typs ausgewertet, falls die Messwerte aller Sensoren des ersten Typs innerhalb des Messbereichs liegen und ansonsten wird mindestens einer der Sensoren des zweiten Typs ausgewertet.

Dies bedeutet, dass sobald ein Messwert eines der Sensoren des ersten Typs seinen Messbereich verlässt, der Strom durch mindestens einen Sensor des zweiten Typs, insbesondere durch eine gewichtete Summe über die Sensoren des zweiten Typs, berechnet. Erst wenn die Messwerte aller Sensoren vom ersten Typ aus dem gültigen Bereich stammen, wird der Stromwert über mindestens einen der Sensoren des ersten Typs, insbesondere über eine gewichtete Summe über die Sensoren des ersten Typs, berechnet. Damit tragen alle Sensoren zur verbesserten Strombestimmung bei und es kann ein Messwert mit einer besonders hohen Genauigkeit bestimmt werden.

Bei einer weiteren vorteilhaften Ausgestaltung der Erfindung wird während der Bestimmung der Stromstärke durch die Sensoren des ersten Typs ein Korrekturwert für den Offset der Sensoren des zweiten Typs in Abhängigkeit der Messwerte aus den Sensoren des zweiten Typs, insbesondere zusätzlich in Abhängigkeit der durch die Sensoren des ersten Typs bestimmten Stromstärke, ermittelt. Wird gerade der gültige Stromwert die Sensoren des ersten Typs berechnet, wird parallel dazu in einer Art Nebenrechnung auch der Strom der Sensoren des zweiten Typs berechnet. Die Berechnung kann dabei in beiden und in einem der Fälle über eine gewichtete Summe der Messwerte der einzelnen Sensoren erfolgen. Daraus wird dann ein aktueller Korrekturwert für den Offset der Sensoranordnung des zweiten Typs ermittelt. Dabei bestimmt sich der durch die Sensoren des zweiten Typs gemessene Strom zu

$$I_{Typ\,II} = \sum a_j^{Typ\,II} \cdot S_j^{Typ\,II} - I_{off,II} - \overline{K_{off,II}} \,.$$

Daraus ergibt sich ein einzelner Wert für den Korrekturfaktor zu

$$K_{off,II} = \sum a_j^{Typ\,II} \cdot S_j^{Typ\,II} - I_{off,II} - \left( \sum a_j^{Typ\,I} \cdot S_j^{Typ\,I} - I_{off,I} \right).$$

Vorteilhafterweise wird der Korrekturwert für den Offset der Sensoranordnung des zweiten Typs $K_{off,II}$ in einem möglichst großen Bereich von gültigen Werten der Sensoranordnung des ersten Typs ermittelt. Für die Korrektur des Stromwertes bei gültiger Berechnung über die gewichtete Summe über die Sensoren des zweiten Typs wird dann der Mittelwert der letzten Korrekturwerte für den Offset der Sensoranordnung des zweiten Typs $K_{off,II}$ verwendet.

Im Folgenden wird die Erfindung anhand der in den Figuren dargestellten Ausführungsbeispiele näher beschrieben und erläutert. Es zeigen:

FIG 1   ein erstes Ausführungsbeispiel einer Strommessvorrichtung,

FIG 2   ein zweites Ausführungsbeispiel einer Strommessvorrichtung und

FIG 3   eine mögliche Realisierung eines Verfahrens zur Offsetkorrektur.

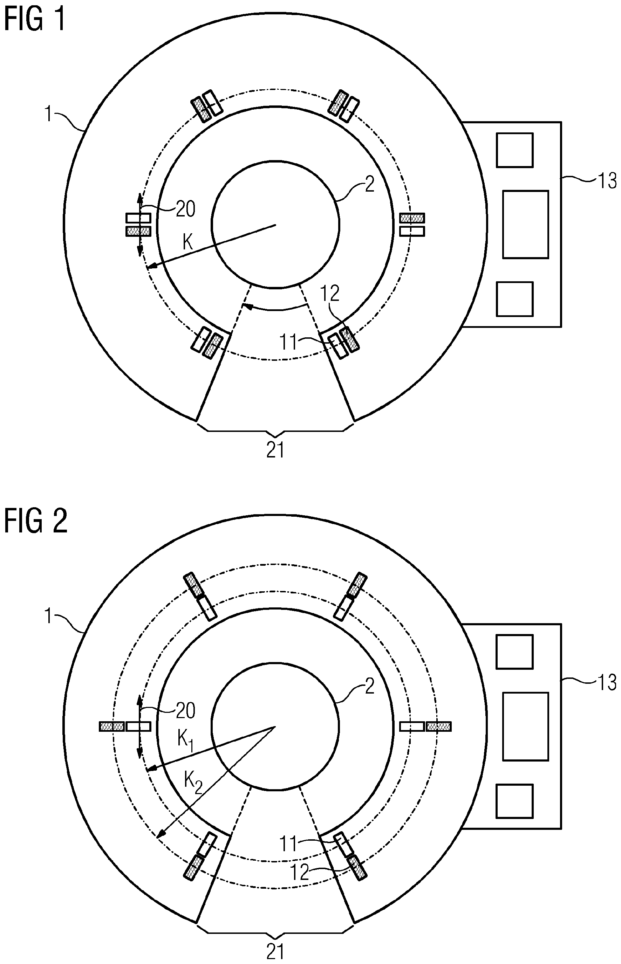

Die FIG 1 zeigt ein erstes Ausführungsbeispiel einer Strommessvorrichtung 1 um einen elektrischen Leiter 2. Die Strommessvorrichtung 1 weist dabei eine Vielzahl Sensoren 11 eines ersten Typs und jeweils benachbart dazu eine Vielzahl Sensoren 12 eines zweiten Typs. Benachbart heißt in diesem Ausführungsbeispiel, dass der Abstand zwischen zwei Sensoren kleiner ist, als die kleinste Ausdehnung der Sensoren. Die Typen unterscheiden sich dabei beispielsweise in ihren Messprinzipien. Die Sensoren unterschiedlichen Typs sind auf einer gemeinsamen Kreisbahn K angeordnet. Dabei erfolgt die Anordnung derart, dass die durch den jeweiligen Sensor messbare Feldausrichtung 20 tangential zur Kreisbahn ausgerichtet ist. Um die Messsignale der einzelnen Sensoren auswerten zu können weist die Strommessvorrichtung 1 eine Auswerteelektronik 13 auf. Um die Messvorrichtung 1 auf einfache Weise um den elektrischen Leiter anzuordnen, hat es sich als vorteilhaft erwiesen im Kreisförmigen Aufbau der Strommessvorrichtung 1 eine winkelförmige Öffnung 21 vorzusehen. Je flexibler die Strommessvorrichtung 1 ist, desto kleiner kann die winkelförmige Öffnung 21 ausgebildet sein.

Die FIG 2 zeigt ein weiteres Ausführungsbeispiel der Strommessvorrichtung 1. Zur Vermeidung von Wiederholungen wird auf die Beschreibung zur FIG 1 und auf die dort eingeführten Bezugzeichen verwiesen. Bei diesem Ausführungsbeispiel sind die Sensoren der unterschiedlichen Typen jeweils auf unterschiedlichen, konzentrischen Kreisbahnen $K_1$, $K_2$ benachbart angeordnet. Benachbart heißt in diesem Ausführungsbeispiel, dass der Abstand zwischen zwei Sensoren kleiner ist, als die kleinste Ausdehnung der Sensoren. Auch mit dieser Anordnung lässt sich vergleichbar gute Messergebnis erzielen wie im Aufbau des vorhergehend erläuterten Ausführungsbeispiels.

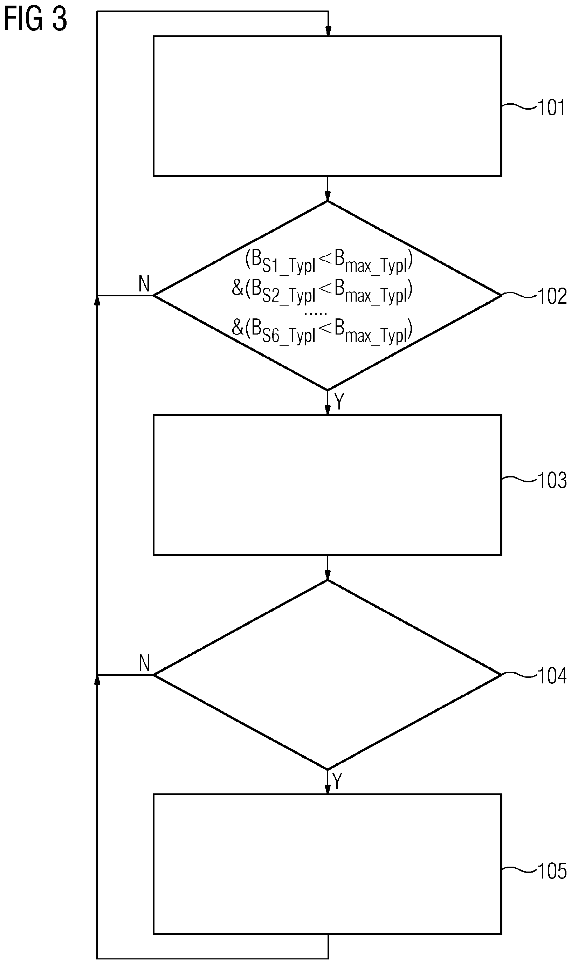

Die FIG 3 zeigt ein Ablaufdiagramm für ein vorteilhaftes Messverfahren für eine Offsetkorrektur. In einem ersten Schritt 101 erfolgt die Strommessung durch die Sensoren des ersten und des zweiten Typs. In einer Entscheidung 102 wird überprüft, ob sich alle Messwerte der Sensoren des ersten Typs im erlaubten Messbereich befinden. Ist dies nicht der Fall, wird im Pfad N (für no) zum ersten Schritt 101 zurückgekehrt und neue Messwerte aufgenommen. Im anderen Fall Y (für yes), in dem die Messwerte der Sensoren des ersten Typs dann im erlaubten Bereich liegen, wird der Offset $K_{offB}$ aus den Werten der Sensoren 12 des zweiten Typs im Schritt 103 bestimmt. Erst bei Erreichen einer Mindestmenge an Werten für $K_{offB}$ wird ein Offsetwert für die Sensoren des zweiten Typs im Schritt 105 festgelegt. Andernfalls sorgt die Entscheidung 104 dafür, dass wieder mit der Bestimmung neuer Messwerte im Schritt 101 fortgefahren wird.

Zusammenfassend betrifft die Erfindung eine Strommessvorrichtung. Zur Verbesserung der Messgenauigkeit wird vorgeschlagen, dass die Strommessvorrichtung mindestens zwei Sensoren eines ersten Typs und mindestens zwei Sensoren eines zweiten Typs aufweist, wobei die Sensoren des ersten Typs eine höhere Empfindlichkeit aufweisen als die Sensoren des zweiten Typs, wobei die ersten Sensoren radialsymmetrisch auf einer ersten Kreisbahn und die zweiten Sensoren radialsymmetrisch auf einer zweiten Kreisbahn angeordnet sind, wobei jeweils ein Sensor des ersten Typs benachbart zu einem Sensor des zweiten Typs angeordnet ist. Weiter betrifft die Erfindung ein Verfahren zur Strommessung mittels einer solchen Strommessvorrichtung, wobei zur Bestimmung der Stromstärke mindestens einer der Sensoren des ersten Typs ausgewertet wird, falls die Messwerte mindestens zweier Sensoren des ersten Typs innerhalb des Messbereichs liegen und ansonsten mindestens ein Sensor des zweiten Typs ausgewertet wird.

**Patentansprüche**

1.   Verfahren zur Strommessung mittels einer Strommessvorrichtung, wobei die Strommessvorrichtung (1)

- mindestens zwei Sensoren (11) eines ersten Typs
- mindestens zwei Sensoren (12) eines zweiten Typs aufweist, wobei die Sensoren (11) des ersten Typs eine höhere Empfindlichkeit aufweisen als die Sensoren (12) des zweiten Typs, wobei die Sensoren (11) des ersten Typs radialsymmetrisch auf einer ersten umlaufenden Bahn, insbesondere einer Ellipse oder einer ersten Kreisbahn ($K_1$), und die Sensoren (12) des zweiten Typs radialsymmetrisch auf einer zweiten umlaufenden Bahn, insbesondere einer Ellipse oder einer zweiten Kreisbahn ($K_2$), angeordnet sind, wobei jeweils ein Sensor (11) des ersten Typs benachbart zu einem Sensor (12) des zweiten Typs angeordnet ist,

**dadurch gekennzeichnet, dass** die Sensoren (11) des ersten Typs Flux-Gate Feldsensoren und die Sensoren (12) des zweiten Typs Hall-Sensoren sind, wobei die Sensoren (11) des ersten Typs eine um den Faktor 5 bis 20 höhere Empfindlichkeit aufweisen als die Sensoren (12) des zweiten Typs, wobei zur Bestimmung der Stromstärke mindestens einer der Sensoren (11) des ersten Typs ausgewertet wird, falls die Messwerte mindestens zweier Sensoren (11) des ersten Typs innerhalb des Messbereichs liegen und ansonsten mindestens ein Sensor (12) des zweiten Typs ausgewertet wird.

2. Verfahren nach Anspruch 1, wobei zur Bestimmung der Stromstärke mindestens einer der Sensoren (11) des ersten Typs ausgewertet werden, falls die Messwerte aller Sensoren (11) des ersten Typs innerhalb des Messbereichs liegen und ansonsten die Sensoren (12) des zweiten Typs ausgewertet werden.

3. Verfahren nach einem der Ansprüche 1 oder 2, wobei während der Bestimmung der Stromstärke durch die Sensoren (11) des ersten Typs ein Korrekturwert für den Offset der Sensoren des zweiten Typs in Abhängigkeit der Messwerte aus den Sensoren (12) des zweiten Typs in Abhängigkeit der durch die Sensoren (11) des ersten Typs bestimmten Stromstärke ermittelt wird.

**Claims**

1. Method for measuring a current by means of a current-measuring device, wherein the current-measuring device (1)

   - has at least two sensors (11) of a first type
   - has at least two sensors (12) of a second type,
   wherein the sensors (11) of the first type have a higher sensitivity than the sensors (12) of the second type, wherein the sensors (11) of the first type are arranged with radial symmetry on a first circumferential path, in particular an ellipse or a first circular path ($K_1$), and the sensors (12) of the second type are arranged with radial symmetry on a second circumferential path, in particular an ellipse or a second circular path ($K_2$), wherein in each case a sensor (11) of the first type is arranged adjacent to a sensor (12) of the second type, **characterised in that** the sensors (11) of the first type are flux-gate field sensors and the sensors (12) of the second type are Hall sensors, wherein the sensors (11) of the first type have a sensitivity which is higher by the factor 5 to 20 compared to the sensors (12) of the second type, wherein in order to determine the current intensity at least one of the sensors (11) of the first type is evaluated, if the measurement values of at least two sensors (11) of the first type lie within the measurement range and otherwise at least one sensor (12) of the second type is evaluated.

2. Method according to claim 1, wherein in order to determine the current intensity, at least one of the sensors (11) of the first type is evaluated, if the measurement values of all sensors (11) of the first type lie within the measurement range and otherwise the sensors (12) of the second type are evaluated.

3. Method according to one of claims 1 or 2, wherein during the determination of the current intensity by the sensors (11) of the first type, a correction value for the offset of the sensors of the second type is ascertained as a function of the measurement values from the sensors (12) of the second type as a function of the current intensity determined by the sensors (11) of the first type.

**Revendications**

1. Procédé de mesure du courant au moyen d'un système de mesure du courant, dans lequel le système (1) de mesure du courant a

   - au moins deux capteurs (11) d'un premier type,
   - au moins deux capteurs (12) d'un deuxième type,
   dans lequel les capteurs (11) du premier type ont une sensibilité plus grande que les capteurs (12) du deuxième type, dans lequel les capteurs (11) du premier type sont disposés à symétrie radiale sur un premier tracé faisant le tour, notamment sur une ellipse ou un premier tracé ($K_1$) circulaire, et les capteurs (12) du deuxième type sont disposés à symétrie radiale sur un deuxième tracé faisant le tour, notamment sur une ellipse ou un deuxième tracé ($K_2$) circulaire, dans lequel, respectivement, un capteur (11) du premier type est disposé au voisinage d'un capteur (12) du deuxième type, **caractérisé en ce que** les capteurs (11) du premier type sont des magnétomètres et les capteurs (12) du deuxième type des capteurs de Hall, les capteurs (11) du premier type ayant une sensibilité plus grande, du facteur 5 à 20, que les capteurs (12) du deuxième type, dans lequel, pour la détermination des intensités de courant, on exploite au moins l'un des capteurs (11) du premier type, si les valeurs de mesure d'au moins deux capteurs (11) du premier type se trouvent dans une plage de mesure et sinon, on exploite au moins un capteur (12) du deuxième type.

2. Procédé suivant la revendication 1, dans lequel, pour la détermination des intensités de courant, on exploite au moins l'un des capteurs (11) du premier type, si les valeurs de mesure de tous les capteurs (11) du premier type se trouvent dans la plage de mesure et sinon, on exploite les capteurs (12) du deuxième type.

3. Procédé suivant l'une des revendications 1 ou 2, dans lequel, pendant la détermination des intensités de courant par les capteurs (11) du premier type, on détermine une valeur de correction du décalage des capteurs du deuxième type en fonction des valeurs de mesure à partir des capteurs (12) du deuxième type en fonction de l'intensité de courant déterminée par les capteurs (11) du premier type.

FIG 1

1

2

20

K

12

11

21

13

FIG 2

1

2

20

$K_1$

$K_2$

11

12

21

13

FIG 3

$(B_{S1\_TypI} < B_{max\_TypI})$
$\&(B_{S2\_TypI} < B_{max\_TypI})$
.....
$\&(B_{S6\_TypI} < B_{max\_TypI})$

101

102

103

104

105

N

Y

N

Y

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2010001716 A
- US 2005156587 A
- US 2014218018 A